# EUROPEAN PATENT APPLICATION

(11) **EP 0 784 336 A2**
(43) Date of publication of application: **16.07.1997**
(21) Application number: 96309145.9
(22) Date of filing: 13.12.1996
(51) Int. Cl.: H01L 21/00

(54) **Improvements in or relating to the fabrication and processing of semiconductor devices**

(30) Priority: 15.12.1995 US 8663
(71) Applicant: TEXAS INSTRUMENTS INCORPORATED, Dallas Texas 75265 (US); IMEC vzw, B-3001 Leuven Heverlee (BE)
(72) Inventor: Hurd,Trace Q., Plano, Texas 75075 (US); Loewenstein,Lee M., 3090 Overrijse (BE); Mertens,Paul W., c/o IMEC vzw, 3001 Leuven (BE)
(74) Representative: Legg, Cyrus James Grahame

(57) **Abstract**

An embodiment of the instant invention is a method of cleaning a semiconductor substrate, the method comprising the steps of: subjecting the semiconductor substrate to a particle removal process step (step 102); simultaneously cleaning and rinsing the semiconductor substrate in a solution having a pH of approximately 2-6 (step 104 and 106); and drying the semiconductor substrate (step 108). The step of drying can be performed by the Marangoni method, spin drying, or by vapor drying. Preferably, the step of drying the semiconductor substrate is performed by subjecting the semiconductor substrate to an ambient comprised of an inert gas and an organic vapor immediately after the rinsing step, where the organic vapor is preferably comprised of isopropyl alcohol and the inert gas is selected from the group consisting of: nitrogen , argon, helium, or any combination thereof. The solution includes an acid selected from the group consisting of: HC₁, HNO₃, H₃PO₄, H₂SO₄, HF, or acetic acid.

## Description

### FIELD OF THE INVENTION

The instant invention pertains to semiconductor device fabrication and processing, and more specifically to semiconductor wafer surface preparation and cleaning.

### BACKGROUND OF THE INVENTION

In the manufacture of, for example, integrated circuits and liquid crystal displays, contamination of the substrate causes many problems and should be reduced as much as possible. Examples of such contamination are residual particulates, organics, and metals. Typically, wet-processing is utilized in the fabrication of semiconductor devices. A wet cleaning process may consist of a sequence of particle removal and metal removal steps, with a rinsing step performed between them, and concluding with a drying step. Drying is typically accomplished either by spinning the wafer so that the liquid on the wafer will be spun off or by raising the wafers from a cloud of hot isopropyl alcohol vapor which condenses on the surface of the wafer and displaces the water.

This type of wet cleaning process suffers from a particularly serious drawback, specifically, metal removal processes (typically consisting of strongly acidic mixtures) add particles to the surface of the wafer, and particle removal processes (typically comprised of basic/oxidant mixtures) add metals to the surface of the wafer. Hence, a metal removal step followed by a particle removal step will result in residual metals, while the reverse process results in fewer particles but can become contaminated with metals by the final rinsing.

To obtain a low amount of residue on the wafer after drying, a method of drying referred to as "Marangoni drying" was introduced. *See* A. F. M. Leenaars, J. A. M. Huethorst, and J. J. van Oekel, *Marangoni Drying: A New Extremely Clean Drying Process*, A 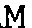 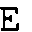 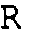 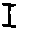 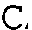 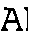 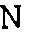 C 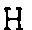 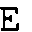 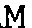 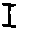 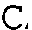 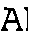 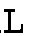 S 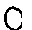 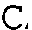 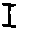 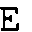 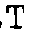 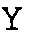 , Langmuir, 6 (11), August 27, 1990, 1701-1703. This method of drying typically includes rinsing the wafer in ultrapure water ("UPW") and then drying the wafer. The drying step consists of immediately subjecting the wafer to a mixture of nitrogen gas combined with a trace of organic vapor as the wafer is slowly removed from the rinsing solution. The organic vapor dissolves into the remnant water and introduces a surface tension gradient in the wetting film on the substrate, thereby causing the water film to quickly drain from the substrate surface.

In light of this, a "Marangoni dryer" consists of a rinse tank with a lid that can be raised and lowered so that wafers are immersed in the tank in the dryer and the lid is lowered. The wafers are rinsed for the desired length of time after which they are raised from the liquid (typically water) by an arm. The atmosphere above the tank is composed of Nitrogen (N₂) which is partially saturated with isopropyl alcohol (IPA) vapor. This is accomplished by bubbling the Nitrogen through the IPA, and results in an atmosphere that creates a finite contact angle between the water and the wafer (even if it is hydrophilic at the surface) and allows the wafers to be lifted dry from the water. *See* European Patent Specification, publication number 0 385 536 B1, by A. F. M. Leenaars and J. J. van Oekel.

Use of the standard Marangoni method using ultrapure water as the liquid can result in metals remaining on the substrate after drying. Hence, it is an object of the instant invention to introduce a method of further reducing the amount of residual metals left on the wafer surface. In addition, it is an object of this invention to reduce the amount of time and equipment required for cleaning a wafer surface.

### SUMMARY OF THE INVENTION

An embodiment of the instant invention is a method of cleaning a semiconductor substrate, the method Comprising the steps of: subjecting the semiconductor substrate to a particle removal process step; simultaneously cleaning and rinsing the semiconductor substrate in a solution having a pH of approximately 2-6; and drying the semiconductor substrate. The step of drying can be performed by the Marangoni method, spin drying, or by vapor drying. Preferably, the step of drying the semiconductor substrate is performed by subjecting the semiconductor substrate to an ambient comprised of an inert gas and an organic vapor immediately after the rinsing step, where the organic vapor is preferably comprised of isopropyl alcohol and the inert gas is selected from the group consisting of: nitrogen , argon, helium, or any combination thereof. The solution includes an acid selected from the group consisting of: HC1, HNO₃, H₃ PO₄, H₂ SO₄, HF, or acetic acid.

Another embodiment of the instant invention is a method of cleaning a semiconductor substrate, the method comprising the steps of: subjecting the semiconductor substrate to a particle removal process step; simultaneously cleaning and rinsing the semiconductor substrate in a solution which is comprised of a complexing/chelating agent; and drying the semiconductor substrate. The step of drying can be performed by the Marangoni method, spin drying, or by vapor drying. Preferably, the step of drying the semiconductor substrate is performed by subjecting the semiconductor substrate to an ambient comprised of an inert gas and an organic vapor immediately after the rinsing step, where the organic vapor is comprised of isopropyl alcohol and the inert gas is selected from the group consisting of: nitrogen, argon, helium, or any combination thereof. Preferably, the complexing/chelating agent is selected from the group consisting of: EDTA, oxalic acid, H₂CO3 or phosphonic acid.

Another embodiment of the instant invention is a method of cleaning a semiconductor substrate, the method comprising the steps of: subjecting the semiconductor substrate to a cleaning process; rinsing the semiconductor substrate in a solution having a pH between approximately 2 and 6. The pH is achieved by adding an acid (from the group of acids including HNO₃, or H₂CO₃, or other acid preferably derivable from a gaseous source mixed with water) to the solution. Preferred acids in the concentrations used should be readily rinsible. Those acids that derive directly from gaseous precursors will work the best, since residues of the acids will volatilize. The solution includes an acid selected from the group consisting of: HCl, HNO₃, HF, Hbr, HI or acetic acid. Other acids such as H₃PO₄ and H₂SO₄ may also be used. This method yields a semiconductor substrate after cleaning that has a low level of metal contamination. The deposition of many metals onto the semiconductor substrate depends on the pH of the water in which they are dissolved and the semiconductor substrate is immersed.

Another embodiment of the instant invention is a method of cleaning a semiconductor substrate, the method comprising the steps of: immersing the semiconductor substrate in a cleaning solution contained in a tank and carrying out the desired cleaning operation; cleaning the semiconductor substrate in a second solution having a pH between approximately 2 and 6 while recirculating this solution; and rinsing the semiconductor substrate in the second solution while having the solution overflow the tank. In a specific embodiment two tanks can be used for the different process steps. Preferred acids in the concentrations used should be readily rinsible. Those acids that derive directly from gaseous precursors will work the best, since residues of the acids will volatilize. The solution includes an acid selected from the group consisting of: HCl, HNO₃, HF, Hbr, HI or acetic acid. Other commonly available acids such as H₃PO₄ and H₂SO₄ may also be used.

### BRIEF DESCRIPTION OF THE DRAWINGS

The invention will now be further described, by way of example, with reference to the accompanying drawings in which:-
FIGURE 1a is a flow chart illustrating a standard method of cleaning, rinsing, and drying a semiconductor wafer;
FIGURE 1b is a flow chart illustrating the method of one embodiment of the instant invention.
FIGURE 2a is a flow chart illustrating a standard method of cleaning, rinsing, and drying a semiconductor wafer;
FIGURE 2b is a flow chart illustrating the method of a second embodiment of the instant invention;
FIGURE 3 is a cross-sectional diagram of a Marangoni-type drying apparatus which is adapted per the instant invention.
FIGURE 4a is a diagram of an apparatus which utilizes overflow rinsing;
FIGURE 4b is a diagram of an apparatus which utilizes recirculation and overflow rinsing.

### DETAILED DESCRIPTION OF THE DRAWINGS

Particle deposition from liquids onto solid surfaces, during cleaning and rinsing processes, is strongly effected by the pH and ionic strength of the solution. Metal removal is strongly effected by the pH of the solution as well as by any other reactive species which are able to complex or chelate metal that might be in the solution. In a typical cleaning process, metal removing steps are alternated with particle removing steps with UPW rinses in between each step to minimize cross contamination and to eliminate unwanted side reactions. All of these baths are contained in wet benches which occupy a great deal of floor space in a typical wafer fabrication area.

FIGURE 1a illustrates a standard cleaning, rinsing and drying procedure. The method of FIGURE 1a includes performing an SC1 particle removal step (step 10) followed by a rinse (step 12), an SC2 metal removal step (step 14) which is followed by a rinse (step 16) and a drying step (step 18). Each of these steps are performed in separate tanks, and, preferably, the rinse steps utilize ultrapure water so as to reduce the amount of contaminants left on the wafer.

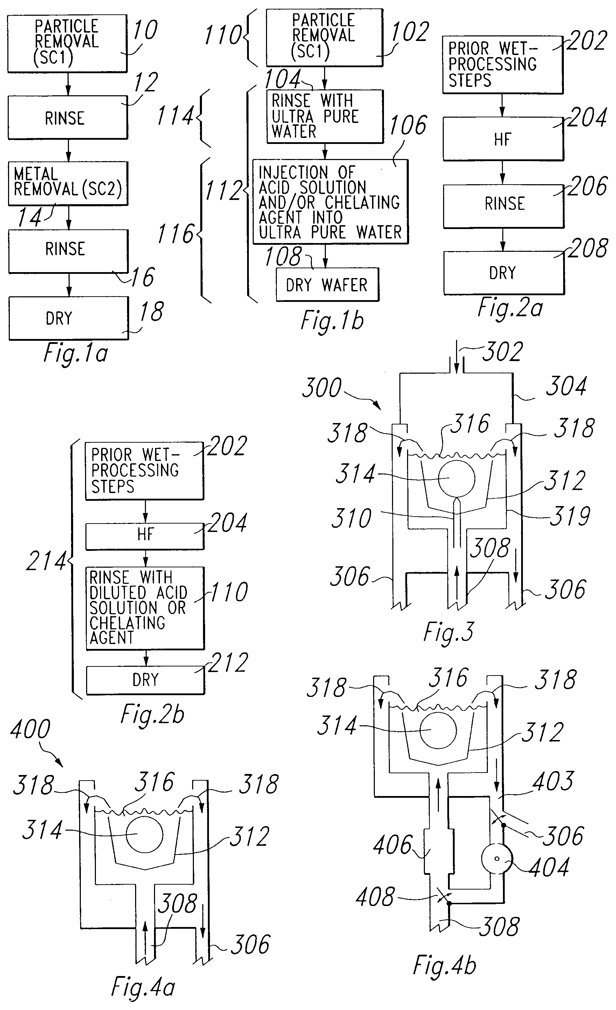

Referring to FIGURE 1b, one embodiment of the instant invention is a method which alleviates the need for trading-off between particle deposition and metal deposition by inventively altering the processing sequence. This embodiment of the instant invention may be performed in two separate processing tanks (tanks 110 and 112) or it may be performed in three processing tanks (tanks 110, 114, and 116). An advantage of the instant invention is that steps 104, 106, and 108 may all be performed in one processing tank. However, if the SC1 process (step 102) solution is fairly concentrated and a longer rinsing process needs to be completed, rinsing step 104 should be performed in a separate tank.

In this embodiment of the instant invention, the wafers are taken directly from a particle removal solution (step 102), rinsed with UPW (step 104) in the Marangoni dryer for a set time following which a small amount of acid is injected into the rinse solution (step 106). The acid could be any that does not detrimentally etch silicon, silicon oxide, silicon nitride or any other wafer structures or materials and which does not react adversely with the organic vapor. If the pH is kept at, or above, the point of zero charge of the Si and SiO₂ surface (approximately 2), then particle deposition will be inhibited, and, since the pH is in the acidic range, metal deposition will also be greatly reduced. The wafers are then lifted from the acidic solution and dried (step 108). Preferably, step 108 is accomplished by using the Marangoni method, but step 108 can also be accomplished by using a spin drying technique or using a vapor drying technique. *See* European Patent Specification, publication number 0 385 536 B1, by A. F. M. Leenaars and J. J. van Oekel.

In step 106, injection of preferably hydrochloric acid into the rinse solution is preferable, but any acid may accomplish acceptable results so long as the acid does not attack the wafer, leave unwanted residues on the wafer, react adversely with the organic vapor, or otherwise interfere with the drying process. Choice of acid (preferably HC1, HNO₃, H₃PO₄, H₂SO₄, HF, or acetic acid) is dictated by preference and materials present on the wafer surface. Complexing or chelating agents may also be used in the rinse solution (whether acidic or neutral), because they may capture metals and they will have little impact on particle addition. The complexing or chelating agent is preferably either: ethylenediaminetetraacetic acid (EDTA), oxalic acid, HCO₃, or phosphonic acid. This embodiment solves the problem of trading off metals and particles, and it also eliminates the need for a final ultrapure water rinse.

The following two tables illustrate the benefit of the instant invention as depicted in FIGURE 1b. The data in the two tables were measured after the test wafers were first subjected to an SC1 cleaning process (NH₄OH:H₂O₂:H₂O at a 0.25:1:5 ratio) that had been spiked with 1 parts per billion by weight (ppb) of Fe, 2 ppb of Zn, and 20 ppb of Ca. This was done so that the levels of these metals would be higher than normal so as to better illustrate the benefit of the instant invention. The Co data is also included because traces of Co were detected after the SC1 cleaning process. The following table lists the metal levels (in terms of 10¹⁰ atoms/cm²) found on a first group of wafers after the SC1 cleaning process; the metal levels for a second group of wafers after an SC1 cleaning process followed by a cleaning/rinsing step using the instant invention where the cleaning rinsing solution had a pH of 3; the metal levels on a third group of wafers after an SC1 cleaning process followed by a cleaning/rinsing step using the instant invention where the cleaning rinsing solution had a pH of 2; and the metal levels found on a fourth group of wafers after an SC1 cleaning process followed by a cleaning/rinsing step using the instant invention where the cleaning rinsing solution had a pH of 1. Specifically, the wafers were immersed in the Marangoni's rinse tank and treated either in a solution with a pH of 1, 2, or 3 for 5 minutes and then dried. These metal levels are as follows:

**Table I**

| | Ca (10¹⁰ atoms/cm²) | Fe (10¹⁰ atoms/cm²) | Co (10¹⁰ atoms/cm²) | Zn (10¹⁰ atoms/cm²) |
|---|---|---|---|---|
| Post-SC1 | 60.6 | 144 | 2.6 | 83.8 |
| Post SC1 and pH3 | 1.4 | 5.5 | 0.1 | 0.3 |
| Post SC1 and pH2 | 2.6 | 15.4 | 0.2 | 0.9 |
| Post SC1 and pH1 | 3.2 | 4.9 | none detected | 3.0 |

Similar measurements were conducted with regards to particles remaining on the wafer after cleaning and rinsing. These measurements were taken with wafers that were relatively clean (less than 50 particles/water which are less than 0.15 micron; and less than 10 particles/water which are less than 0.4 microns) and subjected to 10 minutes in solutions of different pH values in a Marangoni dryer. The pre/post deltas are shown in the following table, with the three rows illustrating different embodiments of the instant invention:

**Table II**

| | > 0.15 microns | > 0.4 microns |
|---|---|---|
| Post pH3 | -1.4 ± 4.9 | -3.8 ± 2.8 |
| Post pH2 | 8.8 ± 6.3 | -0.5 ± 3.1 |
| Post pH1 | 51 ± 8.3 | 21.8 ± 4.6 |

Another embodiment of the instant invention involves using a slightly acidic rinse so as to prevent the contamination of cleaned wafers by metallic impurities.

Preferably, the rinse is comprised of UPW or DIW spiked with HNO₃ so that the rinse has a pH value of around 4 to 6. The second row of data in Table 3 illustrates the improved level of contamination on a semiconductor wafer after using the rinse step of this embodiment of the instant invention.

**Table III**

| Metal | Ca | K | Fe |
|---|---|---|---|
| Surface concentration at high pH (10¹⁰/cm²) | 310 | 3.6 | 7.2 |
| Surface concentration at low pH (10¹⁰/cm²) | 5.8 | 3.5 | 4.6 |
| Relative Reduction | 98% | 4% | 36% |

Table III shows the results of experiments in which semiconductor wafers were cleaned, rinsed and dried in a spin dryer. Metallic contaminants may deposit on wafers during rinsing in a rinse solution of DI water of neutral pH. Using this embodiment of the instant invention, as acid is added to the rinse solution to lower the pH during the rinse, thereby reducing the ability of these metals to contaminate the wafer surface.

The data of Table III was measured after test wafers were subjected to SC1 and SC2 cleaning processes, and then rinsed in solutions of DI water that were spiked with 2 ppm (5.0x10⁻⁸ mol/liter) of Ca as well as equimolar amounts of K and Fe. The data of the second row (reflecting the instant invention) illustrates the effect of a rinse solution which was acidified with nitric acid, and the data in the first row reflects the contamination left on the semiconductor wafer after a rinse with a higher pH value.

Specifically, the contamination level data Table III was measured after the test wafers were subjected to the following processing. First, incoming wafers, p-type (100) Si wafers, were cleaned in an FSI Mercury using an initial clean process. SC1 solution was prepared in a ratio of 0.25:1:5 NH3:H202:H20, and SC2 was prepared in a ratio of 1:1:5 HC1:H202:H20. Second, the baths of these solutions were heated to 50°C, and these cleaning solutions were circulated and filtered. Next, wafers were processed for 10 min in these cleaning solutions. Wafers were, then, lifted from the cleaning tank and excess cleaning chemicals were allowed to drip off for a few seconds. Next, wafers were rinsed in an overflowing mixture of DI water containing both 5.0x10⁻⁸ moles/liter of each metallic species (Ca, Fe and K) and nitric acid. The nitric acid concentration was varied in different experimental trials from 1x10⁻⁴ moles/liter to 2x10⁻⁶ moles/liter. The wafers were then spun dry without any additional rinsing. Wafers were subjected to vapor phase decomposition (VPD). Contaminants were then collected with the GeMeTec pad scan for droplet surface etching (DSE) which moves a droplet of HF:H202:H20 (0.9:1.8:60 ml). The droplet was moved from the center of the wafer to the edge in a spiral, and then back to the center. After this, the spot of solution was evaporated under a heat lamp. The location of the dried spots were determined with the Censor particle counter-mapper. This spot was then measured by an Atomica TXFF 8010.

Table III contains three rows of data: the surface concentration of metal at high pH (approximately 6), the surface concentration of metal after the processing of the instant invention (i.e. rinsing at a low pH value -- approximately 4), and the relative reduction in surface concentration due to the lower pH rinsing. It can be seen that the addition of the nitric acid to the rinse as per this embodiment of the instant invention is beneficial for the reduction of the surface concentration of Ca. The other metals, K and Fe, are reduced to a lesser extent, but these also are initially present to a lesser extent as well. The final surface concentration of all three metals is similarly low. This embodiment of the present invention can be executed while recirculating the rinsing solution, and rinsing the semiconductor substrate in the second solution while having the solution overflow the tank. In a specific embodiment two tanks can be used for the different process steps. Preferred acids in the concentrations used should be readily rinsible. Those acids that derive directly form gaseous precursors will work the best, since residues of the acids will volatilize. The solution includes an acid selected from the group consisting of: HC1, HNO₃, HF, Hbr, HI or acetic acid. Other commonly available acids such as H₃PO₄ and H₂SO₄ may also be used.

FIGURE 2a illustrates another wet processing flow. In this process flow, wet-processing (preferably one which includes an SC1 particle removal step) is performed (step 202) followed by HF step 204. HF step 204 may be performed so as to remove any unwanted oxide regions, such as native oxide regions, and some particulates. HF step 204 is followed by rinse step 206 and dry step 208. Each of these separate steps are performed in separate tanks.

FIGURE 2b illustrates a wet processing flow which utilizes an inventive feature of the instant invention. As with the process flow of FIGURE 2a, wet processing (preferably including an SC1 particle removal step) and an HF step are initially performed. However, unlike the process flow of FIGURE 2a, the process flow of this embodiment of the instant invention includes a rinse step with UPW which is later injected with either a slightly acidic solution or a chelating agent (step 210). After this step, the semiconductor wafer should be fairly free of particulates and metal residue. Therefore, any type of drying step can be performed in drying step 212. However, a Marangoni-type method is preferred. Steps 210 and 212 are preferably performed in one tank (tank 214).

In a specific embodiment, a Marangoni-type method is preferred. Steps 210 and 212 are preferably performed in one tank (tank 214).

Referring collectively to Figures 3, 4a, and 4b, structures with similar reference numeral are intended to be similar structures. Therefore, structures described in reference to Figure 3 may not be described in reference to the other two figures.

FIGURE 3 illustrates apparatus 300 which has been adapted per an embodiment of the instant invention. Basically, apparatus 300 is a Marangoni-type drying apparatus which has been modified 50 as to facilitate processing per the method of the instant invention. Wafers 314 and cassette 312 are immersed in tank 319 so that chemicals 316 (preferably UPW mixed with a slightly acidic solution or a chelating agent) may flow around wafers 314 and out of tank 319 (overflow 318) and out drains 306. Removable cover 304 covers the tank and a gas (preferably N₂ and IPA) is injected into the apparatus via opening 302. After the cleaning of wafers 314 in solution 316, the wafers are slowly lifted from solution 316 by arm 310 and emerge dry from the solution.

Figure 4a illustrates an overflow rinse apparatus 400. Solution 316 is introduced via input 308. Solution 316 overflows (shown as overflow 318) and is discarded via drain 306. In apparatus 401 of Figure 4b, solution 316 is introduced via input 308 through valve 408. Overflow 318 goes through opening 403 and switch 402 (which directs the solution to drain 306 or the recycling path) and is either discarded via drain 306 or is recycled. If the solution is to be recycled it goes through recirculation pump 404 and preferably through particle filter 406 which filters out contamination. Particle filter 406 is optional. During recirculation valve 408 is closed.

In essence, the instant invention includes, but is not limited to, altering the normal functioning of the Marangoni dryer by changing the liquid used in its rinsing cycle so as to be either slightly acidic or spiked with some chelating or complexing agents that will capture metals. The method of the instant invention allows for the metal removal step and the rinse step to be done in one process chamber and with reduced processing time. Eliminating the final rinse saves 10 minutes per batch alone.

Although specific embodiments of the present invention are herein described, they are not to be construed as limiting the scope of the invention. Many embodiments of the present invention will become ap parent to those skilled in the art in light of methodology of the specification.

## Claims

1. A method for cleaning a semiconductor substrate comprising:
subjecting said substrate to a particle removal process step;
simultaneously cleaning and rinsing said substrate in a solution having a pH of approximately 2-6; and
drying said substrate.

2. The method of Claim 1, wherein said drying step is performed by a Marangoni method, spin drying, or by vapor drying.

3. The method of Claim 1, wherein drying step is performed by subjecting said substrate to an ambient comprising an inert gas and an organic vapor immediately after said rinsing step.

4. The method of Claim 3, wherein said step of subjecting said substrate to an ambient comprises subjecting said substrate to an organic vapor comprising isopropyl alcohol.

5. The method of Claim 3 or Claim 4, wherein said step of subjecting said substrate to an ambient comprises subjecting said substrate to an inert gas selected from the group consisting of: nitrogen , argon, helium, or any combination thereof.

6. The method of any preceding claim, wherein said step of simultaneously cleaning and rinsing said substrate comprises cleaning and rinsing said substrate in a solution comprised of an acid selected from the group consisting of: HCl, HNO₃, H₃PO₄, H₂SO₄, HF or acetic acid.

7. A method for cleaning a semiconductor substrate comprising:
subjecting said substrate to a particle removal process step;
simultaneously cleaning and rinsing said substrate in a solution which comprises a complexing/chelating agent; and
drying said semiconductor substrate.

8. The method of Claim 7, wherein said drying step is performed by a Marangoni method, spin drying, or by vapor drying.

9. The method of claim 7, wherein said drying step is performed by subjecting said semiconductor substrate to an ambient comprising an inert gas and an organic vapor immediately after said rinsing step.

10. The method of Claim 9, wherein said step of subjecting said substrate to an ambient comprises subjecting said substrate to an organic vapor is comprising isopropyl alcohol.

11. The method of Claim 9 or Claim 10, wherein said step of subjecting said substrate to an ambient comprises subjecting said substrate to an inert gas selected from the group consisting of: nitrogen , argon, helium, or any combination thereof.

12. The method of any of Claims 7 to 11, wherein said step of simultaneously cleaning and rinsing said substrate comprises cleaning and rinsing said substrate in a complexing/chelating agent selected from the group consisting of: EDTA, oxalic acid, HCO₃, or phosphonic acid.
